# EUROPÄISCHE PATENTANMELDUNG

(11) **EP 4 369 393 A1**
(43) Veröffentlichungstag der Anmeldung: **15.05.2024**
(21) Anmeldenummer: 22206635.9
(22) Anmeldetag: 10.11.2022
(51) Int. Cl.: H01L 23/485, C23C 4/134

(54) **HALBLEITERANORDNUNG MIT EINEM SCHALTBAREN HALBLEITERELEMENT UND VERFAHREN ZUR HERSTELLUNG DERSELBEN**

(71) Anmelder: Siemens Aktiengesellschaft, 80333 München (DE)
(72) Erfinder: Stegmeier, Stefan, 81825 München (DE); Wagner, Claus Florian, 90425 Nürnberg (DE); Woiton, Michael, 90425 Nürnberg (DE)
(74) Vertreter: Siemens Patent Attorneys

(57) **Zusammenfassung**

Die Erfindung betrifft eine Halbleiteranordnung (2) mit einem schaltbaren Halbleiterelement (4), welches zumindest ein Steuerkontakt (6) mit einer Steuerkontakt-Kontaktfläche (12) und zumindest einen Lastkontakt (8) mit einer Lastkontakt-Kontaktfläche (14), welche größer als die Steuerkontakt-Kontaktfläche (12) ist, aufweist. Um eine höhere Lebensdauer der Halbleiteranordnung (2) zu erreichen, wird vorgeschlagen, dass ein elektrisch isolierender Werkstoff auf einen an die Steuerkontakt-Kontaktfläche (12) angrenzenden Bereich (34) der Lastkontakt-Kontaktfläche (14) mittels eines additiven Verfahrens zur Ausbildung einer elektrisch isolierenden Schicht (26) aufgebracht ist, wobei ein metallischer Werkstoff mittels eines thermischen Spritzverfahrens auf die Steuerkontakt-Kontaktfläche (12) und die elektrisch isolierende Schicht (26) zur Ausbildung eines metallischen Steuer-Kontaktierungselements (22) mit einer Steuer-Kontaktierungselement-Kontaktfläche (24), welche größer als die Steuerkontakt-Kontaktfläche (12) ist, aufgebracht ist, wobei das Steuer-Kontaktierungselement (22) die Lastkontakt-Kontaktfläche (14) teilweise überlappt.

## Beschreibung

Die Erfindung betrifft eine Halbleiteranordnung mit einem schaltbaren Halbleiterelement.

Ferner betrifft die Erfindung einen Stromrichter mit mindestens einer derartigen Halbleiteranordnung

Darüber hinaus betrifft die Erfindung ein Verfahren zur Herstellung einer Halbleiteranordnung mit einem schaltbaren Halbleiterelement.

Eine derartige Halbleitermodulanordnung kommt in der Regel in einem Stromrichter zum Einsatz. Unter einem Stromrichter ist beispielsweise ein Gleichrichter, ein Wechselrichter, ein Umrichter oder ein Gleichspannungswandler zu verstehen. Die in der Halbleitermodulanordnung zum Einsatz kommenden schaltbaren Halbleiterelemente sind beispielsweise Transistoren, Triacs oder Thyristoren. Die Transistoren sind beispielsweise als Insulated-Gate-Bipolar-Transistoren (IGBTs), Feldeffekttransistoren oder Bipolartransistoren ausgeführt. Derartige schaltbare Halbleiterelemente weisen üblicherweise einen Steueranschluss und Lastanschlüsse mit jeweils einem Kontaktierungsbereich, beispielsweise ein Kontakt-Pad, auf, wobei der Kontaktierungsbereich eines Lastanschlusses in der Regel eine größere Fläche aufweist als der Kontaktierungsbereich eines Steueranschlusses.

Zur Kontaktierung der schaltbaren Halbleiterelemente werden üblicherweise Verdrahtungsmittel aus Aluminium, wie Aluminium-Wire-Bonds, eingesetzt, welche insbesondere bei modernen Aufbau- und Verbindungstechnologien, ein oder gar der lebensdauerbegrenzende Faktor sind. Eine deutlich höhere Lebensdauer verspricht beispielsweise eine kupfer-basierte Aufbau- und Verbindungstechnik, da Kupfer, insbesondere im Vergleich zu Aluminium, bessere Materialeigenschaften wie ein höheres E-Modul und eine höhere elektrische Leitfähigkeit, aufweist. Die kupfer-basierte Aufbau- und Verbindungstechnik umfasst unter anderem Kupfer-Drahtbonden, Druckkontaktierung, insbesondere mittels Kupfer-Stromschienen oder mittels eines Kupferleadframes, und Laserschweißen von Kupferanschlüssen. Die genannten Technologien erfordern jedoch höherer Druckkräfte, wie beim Kupfer-Drahtbonden, oder punktuell höhere Temperaturen, wie beim Laserschweißen, sodass die Gefahr einer Beschädigung des Halbleiterbauelements bei der Herstellung der Halbleiteranordnung erhöht wird.

Vor diesem Hintergrund ist es eine Aufgabe der vorliegenden Erfindung, eine Halbleiteranordnung mit einem schaltbaren Halbleiterelement anzugeben, welches eine höhere Lebensdauer ermöglicht.

Diese Aufgabe wird erfindungsgemäß gelöst durch eine Halbleiteranordnung mit einem schaltbaren Halbleiterelement, welches zumindest ein Steuerkontakt mit einer Steuerkontakt-Kontaktfläche und zumindest einen Lastkontakt mit einer Lastkontakt-Kontaktfläche, welche größer als die Steuerkontakt-Kontaktfläche ist, aufweist, wobei ein elektrisch isolierender Werkstoff auf einen an die Steuerkontakt-Kontaktfläche angrenzenden Bereich der Lastkontakt-Kontaktfläche mittels eines additiven Verfahrens zur Ausbildung einer elektrisch isolierenden Schicht aufgebracht ist, wobei ein metallischer Werkstoff mittels eines thermischen Spritzverfahrens auf die Steuerkontakt-Kontaktfläche und die elektrisch isolierende Schicht zur Ausbildung eines metallischen Steuer-Kontaktierungselements mit einer Steuer-Kontaktierungselement-Kontaktfläche, welche größer als die Steuerkontakt-Kontaktfläche ist, aufgebracht ist, wobei das Steuer-Kontaktierungselement die Lastkontakt-Kontaktfläche teilweise überlappt.

Ferner wird die Aufgabe erfindungsgemäß gelöst durch einen Stromrichter mit mindestens einer derartigen Halbleiteranordnung.

Darüber hinaus wird die Aufgabe erfindungsgemäß gelöst durch ein Verfahren zur Herstellung einer Halbleiteranordnung mit einem schaltbaren Halbleiterelement, welches zumindest ein Steuerkontakt mit einer Steuerkontakt-Kontaktfläche und zumindest einen Lastkontakt mit einer Lastkontakt-Kontaktfläche), welche größer als die Steuerkontakt-Kontaktfläche ist, aufweist, wobei ein elektrisch isolierender Werkstoff auf einen an die Steuerkontakt-Kontaktfläche angrenzenden Bereich der Lastkontakt-Kontaktfläche mittels eines additiven Verfahrens zur Ausbildung einer elektrisch isolierenden Schicht aufgebracht wird, wobei ein metallischer Werkstoff mittels eines thermischen Spritzverfahrens auf die Steuerkontakt-Kontaktfläche und die elektrisch isolierende Schicht zur Ausbildung eines metallischen Steuer-Kontaktierungselements mit einer Steuer-Kontaktierungselement-Kontaktfläche, welche größer als die Steuerkontakt-Kontaktfläche ist, aufgebracht wird, sodass das Steuer-Kontaktierungselement die Lastkontakt-Kontaktfläche teilweise überlappt.

Die in Bezug auf die Halbleiteranordnung nachstehend angeführten Vorteile und bevorzugten Ausgestaltungen lassen sich sinngemäß auf den Stromrichter und das Verfahren übertragen.

Der Erfindung liegt die Überlegung zugrunde die Lebensdauer einer Halbleiteranordnung durch ein metallisches Steuer-Kontaktierungselement bzw. eine Bufferschicht zur Kontaktierung eines Steuerkontakts eines schaltbaren Halbleiterelements zu erhöhen. Das metallische Steuer-Kontaktierungselement ist aus einem metallischen Werkstoff, beispielsweise Silber, Gold, Kupfer, Zink, Molybdän oder eine deren Legierungen hergestellt, und mit dem Steuerkontakt des schaltbaren Halbleiterelements sowie einer elektrisch isolierenden Schicht verbunden, wobei die elektrisch isolierende Schicht aus einem elektrisch isolierenden Werkstoff, z.B. einem Polymer, hergestellt und auf einen an die Steuerkontakt-Kontaktfläche angrenzenden Bereich einer Lastkontakt-Kontaktfläche des Halbleiterelements aufgebracht ist. Somit ist das Steuer-Kontaktierungselement über die elektrisch isolierende Schicht mit der Lastkontakt-Kontaktfläche des Halbleiterelements verbunden und von dieser elektrisch isoliert angeordnet. Ferner überlappt das Steuer-Kontaktierungselement die Lastkontakt-Kontaktfläche in einem angrenzenden Bereich teilweise. Das Steuer-Kontaktierungselement weist eine Steuer-Kontaktierungselement-Kontaktfläche auf, die eine größere Fläche als die Steuerkontakt-Kontaktfläche des Steuerkontakts aufweist. Der elektrisch isolierende Werkstoff wird mittels eines additiven Verfahrens, beispielsweise in flüssiger Form, zur Ausbildung der elektrisch isolierenden Schicht, beispielsweise mit einer Dicke im Bereich von 0,1 µm bis 100 µm, aufgebracht, während der metallische Werkstoff mittels eines thermischen Spritzverfahrens, z.B. mittels Plasmaspritzen, aufgebracht wird. Die mittels des thermischen Spritzverfahrens aufgebrachte metallische Schicht kann eine Schichtdicke im Bereich von 1 µm bis 250 µm, insbesondere 5 µm bis 100 µm, aufweisen.

Durch eine derartige Bufferschicht werden während einer Kontaktierung auftretende Kräfte verteilt, wodurch beispielsweise thermomechanischen Stress, welcher beim Kupfer-Drahtbonden entsteht, minimiert wird, was sich positiv auf die Lebensdauer der Halbleiteranordnung auswirkt. Durch die vergrößerte Kontaktfläche wird eine Kontaktierung mit dickeren und damit stabileren Bonddrähten ermöglicht. Neben der verbesserten Kraftverteilung wirkt die im Vergleich zum Steuerkontakt größere und dickere Bufferschicht toleranzausgleichend, sodass eine Druckkontaktierung, insbesondere mittels Kupfer-Stromschienen, hinsichtlich ihrer Lebensdauer verbessert wird. Darüber hinaus ermöglicht die im Vergleich zum Steuerkontakt größere und dickere Bufferschicht Schmelzregionen im Metall, wodurch eine Kontaktierung von Kupferanschlüssen mittels Laserschweißen zu einer verbesserten Lebensdauer der Halbleiteranordnung führt.

Eine weitere Ausführungsform sieht vor, dass der elektrisch isolierende Werkstoff ein Polymer mit einem Glasübergangstemperaturpunkt > 150°C, insbesondere > 250°C, enthält. Derartige Polymere können unter anderem Polyimide, Polyamide, Polyamidimide sein. Eine elektrisch isolierende Schicht, welche ein derartiges Polymer enthält, ist robust und wird beim Beschichten mittels des thermischen Spritzverfahrens nicht beschädigt. Darüber hinaus weist die Halbleiteranordnung mit einer derartigen elektrisch isolierenden Schicht, insbesondere bei großen Temperaturhüben, eine verbesserte Lebensdauer auf.

Eine weitere Ausführungsform sieht vor, dass der elektrisch isolierende Werkstoff ein Polymer mit thermoplastischen Eigenschaften enthält. Die mittels des thermischen Spritzverfahrens aufgesprühten Metallpartikel verbinden sich durch die thermoplastischen Eigenschaften des Polymers, insbesondere adhäsiv, mit der elektrisch isolierenden Schicht. Durch eine derartige Verklebung wird die Haftung der Bufferschicht verbessert, was zu einer verbesserten Lebensdauer der Halbleiteranordnung führt.

Eine weitere Ausführungsform sieht vor, dass der elektrisch isolierende Werkstoff mittels Jetting, Dispensen oder Siebdruck aufgebracht ist. Derartige additive Verfahren ermöglichen, dass der elektrisch isolierende Werkstoff in flüssiger Form aufgebracht wird, sodass der elektrisch isolierende Werkstoff auf der Chipoberfläche auslaufen kann und somit keine senkrechten Winkel generiert werden. Dies ist förderlich für eine gute Haftung auf dem Chip und somit einer hohen Langzeitfestigkeit.

Eine weitere Ausführungsform sieht vor, dass der elektrisch isolierende Werkstoff thixotropiert ist oder thixotrope Eigenschaften aufweist. Unter Thixotropieren ist insbesondere zu verstehen, dass der elektrisch isolierende Werkstoff in seinem Viskositätsverhalten so beeinflusst ist, dass dieser beispielsweise bis zu einer gewissen Scherspannung nicht fließt, und danach fließt. Eine Thixotropierung reduziert zudem noch den Ausdehnungskoeffizienten, was förderlich für den Beschichtungsprozess ist.

Eine weitere Ausführungsform sieht vor, dass der elektrisch isolierende Werkstoff eine pyrogene Kieselsäure enthält. Eine derartige pyrogene Kieselsäure ist beispielsweise Aerosil, durch die eine geeignete Thixotropierung erreichbar ist.

Eine weitere Ausführungsform sieht vor, dass der metallische Werkstoff mittels des thermischen Spritzverfahrens auf die Lastkontakt-Kontaktfläche zur Ausbildung eines metallischen Last-Kontaktierungselements mit einer Last-Kontaktierungselement-Kontaktfläche aufgebracht ist, wobei das Last-Kontaktierungselement elektrisch isoliert vom Steuer-Kontaktierungselement angeordnet ist. Die mittels des thermischen Spritzverfahrens aufgebrachte metallische Schicht kann, wie das Steuer-Kontaktierungselement, eine Schichtdicke im Bereich von 1 µm bis 250 µm, insbesondere 5 µm bis 100 µm, aufweisen. Durch eine derartige Bufferschicht auf der Lastkontakt-Kontaktfläche werden während einer Kontaktierung auftretende Kräfte verteilt, wodurch beispielsweise thermomechanischer Stress, welcher beim Kupfer-Drahtbonden entsteht, minimiert wird, was sich positiv auf die Lebensdauer der Halbleiteranordnung auswirkt. Neben der verbesserten Kraftverteilung wirkt die im Vergleich zum Lastkontakt dickere Bufferschicht toleranzausgleichend, sodass eine Druckkontaktierung, insbesondere mittels Kupfer-Stromschienen, hinsichtlich ihrer Lebensdauer verbessert wird. Darüber hinaus ermöglicht die im Vergleich zum Lastkontakt dickere Bufferschicht Schmelzregionen im Metall, wodurch eine Kontaktierung von Kupferanschlüssen mittels Laserschweißen zu einer verbesserten Lebensdauer der Halbleiteranordnung führt.

Eine weitere Ausführungsform sieht vor, dass der metallische Werkstoff derartig aufgebracht ist, dass die Steuer-Kontaktierungselement-Kontaktfläche und die Last-Kontaktierungselement-Kontaktfläche bündig abschließen. Durch einen bündigen Abschluss wird der weitere Kontaktierungsprozess vereinfacht und die Kontaktierung erfolgt gleichmäßig, was sich positiv auf die Lebensdauer der Halbleiteranordnung auswirkt.

Eine weitere Ausführungsform sieht vor, dass das metallische Steuer-Kontaktierungselement und/oder des metallischen Last-Kontaktierungselements eine Porosität im Bereich von 1 % bis 50 %, insbesondere 1 % bis 5 %, aufweisen. Die erhöhte Porosität wirkt, insbesondere bei Druckanbindung, toleranzausgleichend. Insbesondere beim späteren Betrieb des Halbleiterelements, beispielsweise beim An- und Ausschalten eines Leistungshalbleiters, sind die unterschiedlichen Ausdehnungskoeffizienten des Halbleiters und der im metallischen Kontaktierungselement verwendeten Metalle durch die Porosität ausgleichbar, was sich positiv auf die Lebensdauer der Halbleiteranordnung auswirkt.

Eine weitere Ausführungsform sieht vor, dass beim thermischen Spritzverfahren metallische Partikel unterschiedlicher Partikelgrößen in einen Plasmastrahl geleitet werden. Beispielsweise werden die metallischen Partikel durch den Plasmastrahl aufgeschmolzen und deren Oberfläche teilweise verdampft. Die Eigenschaften der abgeschiedenen Schicht kann durch die Art und Größe der Partikel, Plasmaparameter wie Temperatur, Plasmadruck usw. aber auch durch äußere Bedingungen wie Abscheidungsgeschwindigkeit, Heiztemperatur, Atmosphäre usw. gezielt eingestellt werden. Auf diese Weise ist eine hohen Langzeitfestigkeit der aufgebrachten Schicht erreichbar.

Im Folgenden wird die Erfindung anhand der in den Figuren dargestellten Ausführungsbeispiele näher beschrieben und erläutert.

Es zeigen:
- FIG 1: eine schematische Darstellung einer ersten Ausführungsform einer Halbleiteranordnung in einer Querschnittsdarstellung,
- FIG 2: eine schematische Darstellung einer zweiten Ausführungsform einer Halbleiteranordnung in einer Querschnittsdarstellung,
- FIG 3: eine schematische Darstellung eines ersten Verfahrens zur Herstellung einer Halbleiteranordnung,
- FIG 4: eine schematische Darstellung eines zweiten Verfahrens zur Herstellung einer Halbleiteranordnung,
- FIG 5: eine schematische Darstellung einer dritten Ausführungsform einer Halbleiteranordnung in einer Querschnittsdarstellung,
- FIG 6: eine schematische Darstellung eines Stromrichters.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

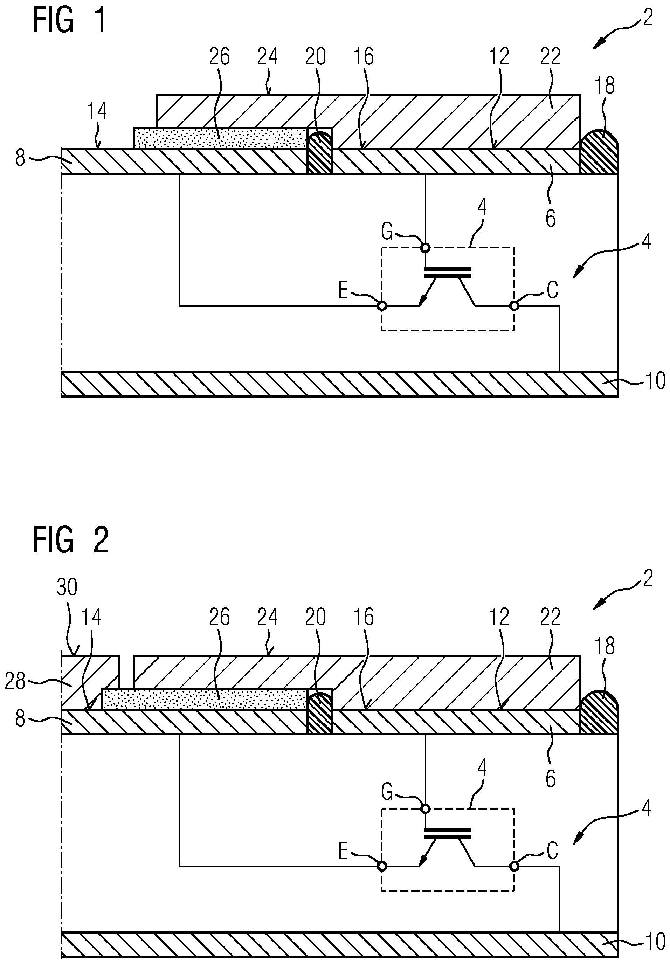

FIG 1 zeigt eine schematische Darstellung einer ersten Ausführungsform einer Halbleiteranordnung 2 in einer Querschnittsdarstellung, welche ein, insbesondere vertikales, schaltbares Halbleiterelement 4 aufweist. Beispielhaft ist das schaltbare Halbleiterelement 4 als ein Insulated-Gate-BipolarTransistor (IGBT) ausgeführt. Weitere Beispiele für schaltbare Halbleiterelemente 4 sind Triacs, Thyristoren oder andere Transistortypen wie Feldeffekttransistoren und Bipolartransistoren. Das schaltbare Halbleiterelement 4 umfasst einen Gate-Anschluss G, einen Kollektor-Anschluss C und einen Emitter-Anschluss E. Der Gate-Anschluss G ist chipintern mit einem Steuerkontakt 6, welcher als Gate-Kontakt ausgeführt ist, verbunden, während der Emitter-Anschluss E chipintern mit einem Lastkontakt 8, welcher als Emitter-Kontakt ausgeführt ist, verbunden ist. Auf einer dem Steuerkontakt 6 und dem Lastkontakt 8 gegenüberliegenden Seite der Halbleiteranordnung 2 ist ein weiterer Lastkontakt 10 angeordnet, welcher chipintern mit dem Kollektor-Anschluss C des vertikalen Halbleiterelements 4 verbunden und als Kollektor-Kontakt ausgeführt ist. Da es sich in FIG 1 beispielhaft um einen vertikalen Halbleiter handelt, sind Lastkontakte 8, 10 auf gegenüberliegenden Seiten angeordnet.

Der Steuerkontakt 6 und die Lastkontakte 8, 10 umfassen jeweils ein metallisches Kontakt-Pad, welches zur Verbindung zumindest eines Verdrahtungsmittels, z.B. eines Bonddrahts, konfiguriert ist. Ferner weisen der Steuerkontakt 6 eine Steuerkontakt-Kontaktfläche 12 und der Lastkontakt 8 eine Lastkontakt-Kontaktfläche 14 auf, wobei die Steuerkontakt-Kontaktfläche 12 wesentlich kleiner als die Lastkontakt-Kontaktfläche 14 ist. Darüber hinaus sind die Steuerkontakt-Kontaktfläche 12 und die Lastkontakt-Kontaktfläche 14 rechteckig oder quadratisch ausgeführt und bündig abschließend auf einer Halbleiteroberfläche 16 angeordnet.

Der Steuerkontakt 6 grenzt an einen elektrisch isolierenden Schutzring 18, welcher beispielhaft die Halbleiteroberfläche 16 und somit die Steuerkontakt-Kontaktfläche 12 und die Lastkontakt-Kontaktfläche 14 überragt. Fener ist zwischen dem Steuerkontakt 6 und dem Lastkontakt 8 eine elektrisch isolierende Zwischenschicht 20 angeordnet, welche beispielhaft die Halbleiteroberfläche 16 ebenfalls überragt. Beispielsweise weisen der elektrisch isolierenden Schutzring 18 und die elektrisch isolierende Zwischenschicht 20 einen dielektrischen Werkstoff, insbesondere Polyimid, auf.

Ein metallisches Steuer-Kontaktierungselement 22 ist flächig mit der Steuerkontakt-Kontaktfläche 12 des Steuerkontakts 6 verbunden, wobei das metallische Steuer-Kontaktierungselement 22 eine auf einer der Steuerkontakt-Kontaktfläche 12 abgewandten Seite angeordnete Steuer-Kontaktierungselement-Kontaktfläche 24 aufweist, welche größer als die Steuerkontakt-Kontaktfläche 12 ist. Beispielsweise ist die Steuer-Kontaktierungselement-Kontaktfläche 24 zumindest vier Mal, insbesondere zumindest acht Mal, so groß wie die Steuerkontakt-Kontaktfläche 12. Das metallische Steuer-Kontaktierungselement 22 ist aus zumindest einem metallischen Werkstoff hergestellt. Zumindest im Bereich der Steuer-Kontaktierungselement-Kontaktfläche 24 enthält das metallische Steuer-Kontaktierungselement 22 Aluminium, Silber, Gold, Kupfer, Zink, Molybdän oder eine deren Legierungen.

Darüber hinaus überlappt das metallische Steuer-Kontaktierungselement 22 die Lastkontakt-Kontaktfläche 14 des Lastkontakts 8 teilweise, wobei im Bereich der Überlappung zwischen dem metallischen Steuer-Kontaktierungselement 22 und der Lastkontakt-Kontaktfläche 14 des Lastkontakts 8 eine elektrisch isolierende Schicht 26 angeordnet ist. Die elektrisch isolierende Schicht 26 ist aus einem elektrisch isolierenden Werkstoff, insbesondere einem dielektrischen Werkstoff, hergestellt. Der elektrisch isolierende Werkstoff kann unter anderem ein Polymer enthalten, welches einen Glasübergangstemperaturpunkt > 150°C, insbesondere > 250°C, aufweist, wie es beispielsweise Polyimid, Polyamide und Polyamidimide mit sich bringen. Der elektrisch isolierende Werkstoff wird beispielsweise in flüssiger Form über einen Film oder eine Fotostrukturierung aufgebracht. Das Aufbringen erfolgt mittels eines additiven Verfahrens, beispielsweise durch Jetting, insbesondere Inkjetting, Dispensen oder Siebdruck. Das Polymer kann auf der Lastkontakt-Kontaktfläche 14 auslaufen und somit werden keine senkrechten Winkel generiert, was förderlich für eine gute Haftung und somit für eine hohen Langzeitfestigkeit ist. Der elektrisch isolierende Werkstoff kann thixotropiert sein oder thixotrope Eigenschaften aufweisen. Beispielsweise wird dem flüssigen Polymer pyrogene Kieselsäure, insbesondere Aerosil, beigemischt.

Nach dem Aufbringen und Trocknen der elektrisch isolierenden Schicht 26 wird der metallische Werkstoff mittels eines thermischen Spritzverfahrens, z.B. mittels Plasmaspritzen, auf die Steuerkontakt-Kontaktfläche 12 und die elektrisch isolierende Schicht 26 zur Ausbildung des metallischen Steuer-Kontaktierungselements 22 aufgebracht, sodass das metallische Steuer-Kontaktierungselement 22 stoffschlüssig mit der Steuerkontakt-Kontaktfläche 12 und der elektrisch isolierenden Schicht 26 verbunden ist. Beispielsweise werden beim thermischen Spritzverfahren metallische Partikel, insbesondere Kupfer- und/oder Molybdän-Partikel, unterschiedlicher Partikelgrößen in einen Plasmastrahl geleitet, wobei die Partikel aufgeschmolzen werden und deren Oberfläche teilweise verdampft. Das mittels des thermischen Spritzverfahrens hergestellte metallische Steuer-Kontaktierungselement 22 weist eine Porosität im Bereich von 1 % bis 50 %, insbesondere 1 % bis 5 %, auf. Das Polymer kann thermoplastische Eigenschaften aufweisen, um mit den aufgesprühten metallischen Partikeln eine adhäsive Verbindung einzugehen.

Durch eine derartige Beschichtung wird beispielsweise eine gate-seitige Kontaktierung mit Verdrahtungsmitteln, insbesondere Bonddrähten, ermöglicht, welche einen größeren Durchmesser aufweisen. Ferner ermöglicht die Beschichtung eine kupfer-basierte Aufbau- und Verbindungstechnik wie z.B. Kupfer-Drahtbonden, Druckkontaktierung, insbesondere mittels Kupfer-Stromschienen oder mittels eines Kupferleadframes, oder Laserschweißen von Kupferanschlüssen, wodurch eine höhere Lebensdauer erreichbar ist. Die Gefahr einer Beschädigung des Halbleiterbauelements 4, beispielsweise durch höherer Druckkräfte, wie beim Kupfer-Drahtbonden, oder punktuell höhere Temperaturen, wie beim Laserschweißen, wird durch die beschriebene Beschichtung minimiert.

FIG 2 zeigt eine schematische Darstellung einer zweiten Ausführungsform einer Halbleiteranordnung 2 in einer Querschnittsdarstellung. Der metallische Werkstoff wird mittels des thermischen Spritzverfahrens zusätzlich auf die Lastkontakt-Kontaktfläche 14 zur Ausbildung eines metallischen Last-Kontaktierungselements 28 mit einer Last-Kontaktierungselement-Kontaktfläche 30 aufgebracht, wobei das Last-Kontaktierungselement 28 elektrisch isoliert vom Steuer-Kontaktierungselement 22 angeordnet ist und wobei die Steuer-Kontaktierungselement-Kontaktfläche 24 und die Last-Kontaktierungselement-Kontaktfläche 30 bündig, insbesondere planbündig, abschließen. Insbesondere wird beim thermischen Spritzverfahren, insbesondere Plasmaspritzen, eine Strukturierung mittels einer Schablone zwischen dem Halbleiterelement 4 und einer Spritzvorrichtung, insbesondere einer Plasmasprühdüse, vorgenommen. Die weitere Ausgestaltung der Halbleiteranordnung 2 in FIG 2 entspricht der in FIG 1.

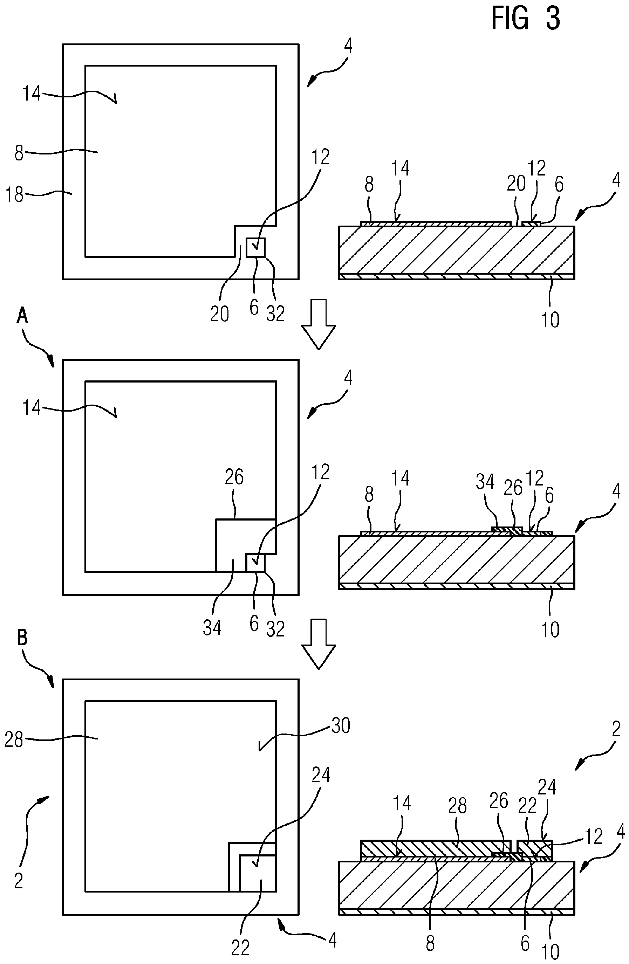

FIG 3 zeigt eine schematische Darstellung eines ersten Verfahrens zur Herstellung einer Halbleiteranordnung 2, welche ein, insbesondere vertikales, schaltbares Halbleiterelement 4 umfasst. Die jeweiligen Schritte des Herstellungsverfahrens sind in FIG 3 linksseitig in einer Draufsicht und rechtsseitig in einer Querschnittsdarstellung dargestellt. Das Halbleiterelement 4 weist einen Steuerkontakt 6 mit einer Steuerkontakt-Kontaktfläche 12 und einen Lastkontakt 8 mit einer Lastkontakt-Kontaktfläche 14, welche um ein Vielfaches größer als die Steuerkontakt-Kontaktfläche 12 ist, auf. Der Steuerkontakt 6 des Halbleiterelements 4 ist in eine Ecke 32 der rechteckigen oder quadratischen Lastkontakt-Kontaktfläche 14 integriert und über eine elektrisch isolierende Zwischenschicht 20 vom Lastkontakt 8 beabstandet und somit elektrisch isoliert angeordnet ist.

Es erfolgt ein Aufgebringen A eines elektrisch isolierenden Werkstoffs auf einen an die Steuerkontakt-Kontaktfläche 12 angrenzenden Bereich 34 der Lastkontakt-Kontaktfläche 14 und der elektrisch isolierenden Zwischenschicht 20 mittels eines additiven Verfahrens zur Ausbildung einer elektrisch isolierenden Schicht 26. Der elektrisch isolierende Werkstoff kann unter anderem ein Polymer enthalten und wird beispielsweise in flüssiger Form über einen Film oder eine Fotostrukturierung aufgebracht. Das additive Verfahren kann Jetting, insbesondere Inkjetting, Dispensen oder Siebdruck beinhalten.

Nach dem Trocknen der elektrisch isolierende Schicht 26 erfolgt in einem weiteren Schritt ein Aufbringen B eines metallischen Werkstoffs mittels eines thermischen Spritzverfahrens auf die Steuerkontakt-Kontaktfläche 12 und die elektrisch isolierende Schicht 26 zur Ausbildung eines metallischen Steuer-Kontaktierungselements 22 sowie auf die Lastkontakt-Kontaktfläche 14 zur Ausbildung eines metallischen Last-Kontaktierungselements 28. Das Last-Kontaktierungselement 28 wird elektrisch isoliert vom Steuer-Kontaktierungselement 22 angeordnet. Das thermische Spritzverfahrens kann z.B. Plasmaspritzen beinhalten. Beispielsweise werden beim thermischen Spritzverfahren metallische Partikel, insbesondere Kupfer- und/oder Molybdän-Partikel, unterschiedlicher Partikelgrößen in einen Plasmastrahl geleitet, wobei die Partikel aufgeschmolzen werden und deren Oberfläche teilweise verdampft. Die Steuer-Kontaktierungselement-Kontaktfläche 24 des Steuer-Kontaktierungselements 22 und die Last-Kontaktierungselement-Kontaktfläche 30 des Last-Kontaktierungselements 28 schließen bündig ab. Die weitere Ausgestaltung der Halbleiteranordnung 2 in FIG 3 entspricht der in FIG 2.

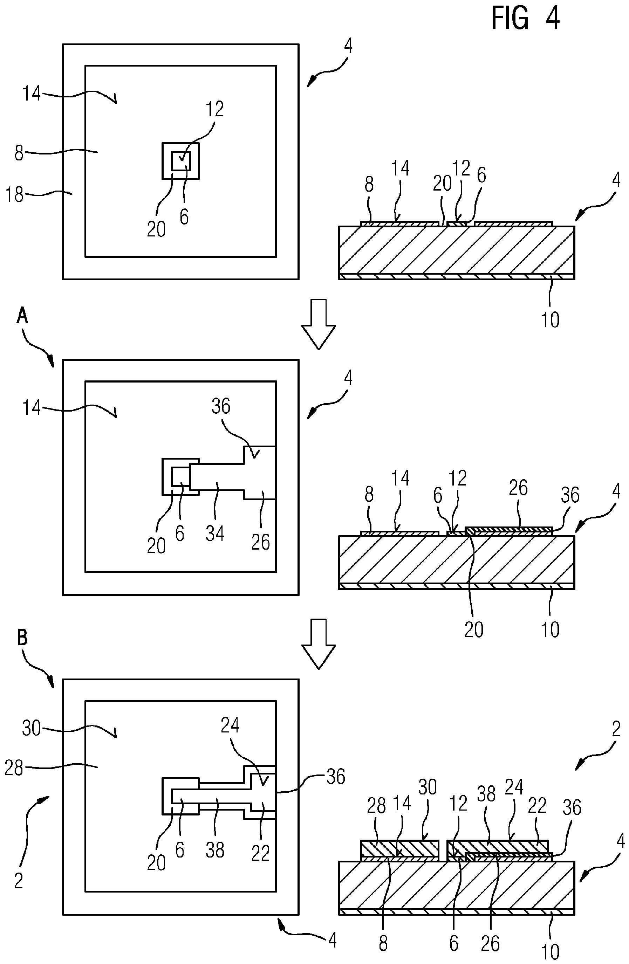

FIG 4 zeigt eine schematische Darstellung eines zweiten Verfahrens zur Herstellung einer Halbleiteranordnung 2, wobei der Steuerkontakt 6 des Halbleiterelements 4 im Wesentlichen mittig innerhalb der rechteckigen oder quadratischen Lastkontakt-Kontaktfläche 14, welche um ein Vielfaches größer als die Steuerkontakt-Kontaktfläche 12 ist, angeordnet ist. Über eine den Steuerkontakt 6 umgebende elektrisch isolierende Zwischenschicht 20 ist dieser vom Lastkontakt 8 beabstandet und somit elektrisch isoliert angeordnet.

Das Aufgebringen A des elektrisch isolierenden Werkstoffs erfolgt auf einen an die Steuerkontakt-Kontaktfläche 12 angrenzenden Bereich 34 der Lastkontakt-Kontaktfläche 14 und der elektrisch isolierenden Zwischenschicht 20 hin zu einer Kantenmitte 36 der rechteckigen oder quadratischen Lastkontakt-Kontaktfläche 14.

Das Aufbringen B des metallischen Werkstoffs mittels des thermischen Spritzverfahrens auf die Steuerkontakt-Kontaktfläche 12 und die elektrisch isolierende Schicht 26 erfolgt unter Ausbildung eines metallischen Steuer-Kontaktierungselements 22, welches an die Kantenmitte 36 der Lastkontakt-Kontaktfläche 14 angrenzt, wobei mittels des thermischen Spritzverfahrens ein Pfad 38 ausgebildet wird, welcher den Steuerkontakt 6 elektrisch leitend mit dem Steuer-Kontaktierungselement 22 verbindet. Die weitere Ausgestaltung des Herstellungsverfahrens in FIG 4 entspricht dem in FIG 3.

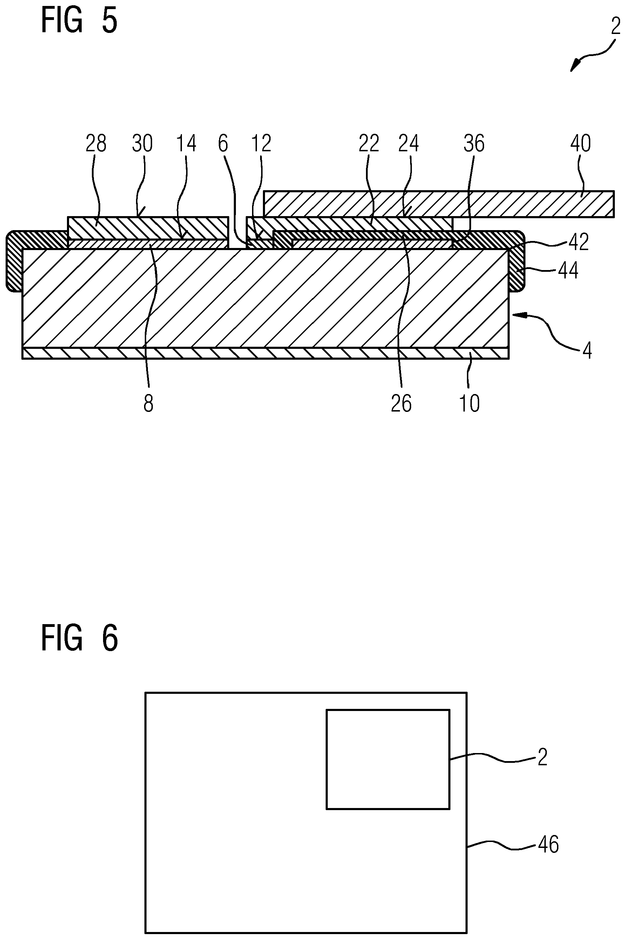

FIG 5 zeigt eine schematische Darstellung einer dritten Ausführungsform einer Halbleiteranordnung 2 in einer Querschnittsdarstellung, wobei ein Verbindungselement 40, insbesondere stoffschlüssig, mit der Steuer-Kontaktierungselement-Kontaktfläche 24 verbunden ist. Der flüssige elektrisch isolierende Werkstoff wird thixotropiert aufgebracht, wobei dieser kontrolliert über die Chipkante 42 hinunterläuft und erstarrt, sodass eine Chipeckenisolation 44 ausgebildet wird. Der elektrisch isolierende Werkstoff weist beispielsweise eine Durchschlagsfestigkeit > 150 kV/mm auf. Insbesondere wenn eine Sägekante des Halbleiterelements 4 auf einem unteren Potential des weiterer Lastkontakts 10 liegt, wird das Risiko eines Überschlags, z.B. zum Verbindungselement 40, durch eine derartige Chipeckenisolation 44 minimiert. Die weitere Ausgestaltung der Halbleiteranordnung 2 in FIG 5 entspricht der in FIG 4.

FIG 6 zeigt eine schematische Darstellung eines Stromrichters 46, welcher beispielhaft eine Halbleiteranordnung 2 umfasst.

Zusammenfassend betrifft die Erfindung eine Halbleiteranordnung 2 mit einem schaltbaren Halbleiterelement 4, welches zumindest ein Steuerkontakt 6 mit einer Steuerkontakt-Kontaktfläche 12 und zumindest einen Lastkontakt 8 mit einer Lastkontakt-Kontaktfläche 14, welche größer als die Steuerkontakt-Kontaktfläche 12 ist, aufweist. Um eine höhere Lebensdauer der Halbleiteranordnung 2 zu erreichen, wird vorgeschlagen, dass ein elektrisch isolierender Werkstoff auf einen an die Steuerkontakt-Kontaktfläche 12 angrenzenden Bereich 34 der Lastkontakt-Kontaktfläche 14 mittels eines additiven Verfahrens zur Ausbildung einer elektrisch isolierenden Schicht 26 aufgebracht ist, wobei ein metallischer Werkstoff mittels eines thermischen Spritzverfahrens auf die Steuerkontakt-Kontaktfläche 12 und die elektrisch isolierende Schicht 26 zur Ausbildung eines metallischen Steuer-Kontaktierungselements 22 mit einer Steuer-Kontaktierungselement-Kontaktfläche 24, welche größer als die Steuerkontakt-Kontaktfläche 12 ist, aufgebracht ist, wobei das Steuer-Kontaktierungselement 22 die Lastkontakt-Kontaktfläche 14 teilweise überlappt.

## Patentansprüche

1. Halbleiteranordnung (2) mit einem schaltbaren Halbleiterelement (4), welches zumindest ein Steuerkontakt (6) mit einer Steuerkontakt-Kontaktfläche (12) und zumindest einen Lastkontakt (8) mit einer Lastkontakt-Kontaktfläche (14), welche größer als die Steuerkontakt-Kontaktfläche (12) ist, aufweist,
wobei ein elektrisch isolierender Werkstoff auf einen an die Steuerkontakt-Kontaktfläche (12) angrenzenden Bereich (34) der Lastkontakt-Kontaktfläche (14) mittels eines additiven Verfahrens zur Ausbildung einer elektrisch isolierenden Schicht (26) aufgebracht ist,
wobei ein metallischer Werkstoff mittels eines thermischen Spritzverfahrens auf die Steuerkontakt-Kontaktfläche (12) und die elektrisch isolierende Schicht (26) zur Ausbildung eines metallischen Steuer-Kontaktierungselements (22) mit einer Steuer-Kontaktierungselement-Kontaktfläche (24), welche größer als die Steuerkontakt-Kontaktfläche (12) ist, aufgebracht ist, wobei das Steuer-Kontaktierungselement (22) die Lastkontakt-Kontaktfläche (14) teilweise überlappt.

2. Halbleiteranordnung (2) nach Anspruch 1,
wobei der elektrisch isolierende Werkstoff ein Polymer mit einem Glasübergangstemperaturpunkt > 150°C, insbesondere > 250°C, enthält.

3. Halbleiteranordnung (2) nach einem der Ansprüche 1 oder 2, wobei der elektrisch isolierende Werkstoff ein Polymer mit thermoplastischen Eigenschaften enthält.

4. Halbleiteranordnung (2) nach einem der vorherigen Ansprüche,
wobei der elektrisch isolierende Werkstoff mittels Jetting, Dispensen oder Siebdruck aufgebracht ist.

5. Halbleiteranordnung (2) nach einem der vorherigen Ansprüche,
wobei der elektrisch isolierende Werkstoff thixotropiert ist oder thixotrope Eigenschaften aufweist.

6. Halbleiteranordnung (2) nach Anspruch 5,
wobei der elektrisch isolierende Werkstoff eine pyrogene Kieselsäure enthält.

7. Halbleiteranordnung (2) nach einem der vorherigen Ansprüche,
wobei der metallische Werkstoff mittels des thermischen Spritzverfahrens auf die Lastkontakt-Kontaktfläche (14) zur Ausbildung eines metallischen Last-Kontaktierungselements (28) mit einer Last-Kontaktierungselement-Kontaktfläche (30) aufgebracht ist,
wobei das Last-Kontaktierungselement (28) elektrisch isoliert vom Steuer-Kontaktierungselement (22) angeordnet ist.

8. Halbleiteranordnung (2) nach Anspruch 7,
wobei der metallische Werkstoff derartig aufgebracht ist, dass die Steuer-Kontaktierungselement-Kontaktfläche (24) und die Last-Kontaktierungselement-Kontaktfläche (30) bündig abschließen.

9. Halbleiteranordnung (2) nach einem der Ansprüche 7 oder 8, wobei das metallischen Steuer-Kontaktierungselements (22) und/oder des metallischen Last-Kontaktierungselements (28) eine Porosität im Bereich von 1 % bis 50 %, insbesondere 1 % bis 5 %, aufweisen.

10. Stromrichter (46) mit mindestens einer Halbleiteranordnung (2) nach einem der vorherigen Ansprüche.

11. Verfahren zur Herstellung einer Halbleiteranordnung (2) mit einem schaltbaren Halbleiterelement (4),
welches zumindest ein Steuerkontakt (6) mit einer Steuerkontakt-Kontaktfläche (12) und zumindest einen Lastkontakt (8) mit einer Lastkontakt-Kontaktfläche (14), welche größer als die Steuerkontakt-Kontaktfläche (12) ist, aufweist,
wobei ein elektrisch isolierender Werkstoff auf einen an die Steuerkontakt-Kontaktfläche (12) angrenzenden Bereich (34) der Lastkontakt-Kontaktfläche (14) mittels eines additiven Verfahrens zur Ausbildung einer elektrisch isolierenden Schicht (26) aufgebracht wird,
wobei ein metallischer Werkstoff mittels eines thermischen Spritzverfahrens auf die Steuerkontakt-Kontaktfläche (12) und die elektrisch isolierende Schicht (26) zur Ausbildung eines metallischen Steuer-Kontaktierungselements (22) mit einer Steuer-Kontaktierungselement-Kontaktfläche (24), welche größer als die Steuerkontakt-Kontaktfläche (12) ist, aufgebracht wird,
sodass das Steuer-Kontaktierungselement (22) die Lastkontakt-Kontaktfläche (14) teilweise überlappt.

12. Verfahren nach Anspruch 11,
wobei der elektrisch isolierende Werkstoff mittels Jetting, Dispensen oder Siebdruck aufgebracht wird.

13. Verfahren nach einem der Ansprüche 11 oder 12,
wobei ein Polymer mit einem Glasübergangstemperaturpunkt > 150°C, insbesondere > 250°C, zur Ausbildung der elektrisch isolierenden Schicht (26) aufgebracht wird.

14. Verfahren nach einem der Ansprüche 11 bis 13,
wobei der metallische Werkstoff mittels des thermischen Spritzverfahrens auf die Lastkontakt-Kontaktfläche (14) zur Ausbildung eines metallischen Last-Kontaktierungselements (28) mit einer Last-Kontaktierungselement-Kontaktfläche (30) aufgebracht wird,
wobei das Last-Kontaktierungselement (28) elektrisch isoliert vom Steuer-Kontaktierungselement (22) angeordnet wird.

15. Verfahren nach einem der Ansprüche 11 bis 14,
wobei beim thermischen Spritzverfahren metallische Partikel unterschiedlicher Partikelgrößen in einen Plasmastrahl geleitet werden.
